(19) Europäisches Patentamt
European Patent Office
Office européen des brevets

(11) **EP 2 921 873 B1**

(12) **FASCICULE DE BREVET EUROPEEN**

(45) Date de publication et mention
de la délivrance du brevet:
**08.04.2020 Bulletin 2020/15**

(51) Int Cl.:
*G01R 33/34* *(2006.01)*   *G01R 33/341* *(2006.01)*
*G01R 33/3415* *(2006.01)*   *G01R 33/36* *(2006.01)*

(21) Numéro de dépôt: **15158277.2**

(22) Date de dépôt: **09.03.2015**

(54) **ÉMETTEUR-RÉCEPTEUR À POLARISATIONS CIRCULAIRES POUR L'IMAGERIE PAR RESONANCE MAGNETIQUE**

Sender-Empfänger mit Kreispolarisierungen für Magnetresonanzbildgebung

Transceiver with circular polarisation for magnetic resonance imaging

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **10.03.2014 FR 1451923**

(43) Date de publication de la demande:
**23.09.2015 Bulletin 2015/39**

(73) Titulaire: **COMMISSARIAT À L'ÉNERGIE ATOMIQUE ET AUX ÉNERGIES ALTERNATIVES**
**75015 Paris (FR)**

(72) Inventeurs:
• **Ferrand, Guillaume**
**75014 PARIS (FR)**
• **Luong, Michel**
**92330 SCEAUX (FR)**

(74) Mandataire: **Lebkiri, Alexandre**
**Cabinet Camus Lebkiri**
**25, Rue de Maubeuge**
**75009 Paris (FR)**

(56) Documents cités:
**WO-A1-2007/141505    US-A1- 2007 229 076**

• **ZHANG ET AL.: "Design of a Patch Antenna for Creating Traveling Waves at 7 Tesla", PROCEEDINGS OF THE INTERNATIONAL SOCIETY FOR MAGNETIC RESONANCE IN MEDICINE, 17TH SCIENTIFIC MEETING AND EXHIBITION, HONOLULU, HAWAII, USA, 18-24 APRIL 2009, vol. 17, 4746, 4 avril 2009 (2009-04-04), XP040611977,**
• **WONG KIN-LU ET AL: "Circularly polarised microstrip antenna with a tuning stub", ELECTRONICS LETTERS, IEE STEVENAGE, GB, vol. 34, no. 9, 30 avril 1998 (1998-04-30) , pages 831-832, XP006009645, ISSN: 0013-5194, DOI: 10.1049/EL:19980593**
• **WONG KIN-LU ET AL: "Small slot-coupled circularly-polarised microstrip antenna with modified cross-slot and bent tuning-stub", ELECTRONICS LETTERS, IEE STEVENAGE, GB, vol. 34, no. 16, 6 août 1998 (1998-08-06), pages 1542-1543, XP006010141, ISSN: 0013-5194, DOI: 10.1049/EL:19981100**
• **G. SHAJAN ET AL: "Rat brain MRI at 16.4T using a capacitively tunable patch antenna in combination with a receive array", NMR IN BIOMEDICINE, vol. 25, no. 10, 17 février 2012 (2012-02-17), pages 1170-1176, XP055148631, ISSN: 0952-3480, DOI: 10.1002/nbm.2786**
• **PANG Y. ET AL.: "MR experiment validation of parallel traveling-wave with quadrature patch antenna transceiver array", PROCEEDINGS OF THE INTERNATIONAL SOCIETY FOR MAGNETIC RESONANCE IN MEDICINE, 19TH ANNUAL MEETING AND EXHIBITION, MONTREAL, QUEBEC, 7-13 MAY 2011, vol. 19, 1904, 23 avril 2011 (2011-04-23), XP040618571,**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

EP 2 921 873 B1

- **Y PANG ET AL:** "Parallel Traveling-wave MRI: Antenna Array Approach to Traveling-wave MRI for Parallel Transmission and Acquisition", PROCEEDINGS OF THE INTERNATIONAL SOCIETY FOR MAGNETIC RESONANCE IN MEDICINE, 18TH SCIENTIFIC MEETING AND EXHIBITION, STOCKHOLM, SWEDEN, 1-7 MAY 2010, vol. 18, 17 avril 2010 (2010-04-17), page 3794, XP055148840,
- **X ZHANG ET AL:** "Single-feed quadrature coils as transceiver array elements for improved SNR and transmit efficiency", PROCEEDINGS OF THE INTERNATIONAL SOCIETY FOR MAGNETIC RESONANCE IN MEDICINE, 17TH SCIENTIFIC MEETING AND EXHIBITION, HONOLULU, HAWAII, USA, 18-24 APRIL 2009, vol. 17, 4 avril 2009 (2009-04-04), page 3014, XP055149105,
- **XIAOYU YANG ET AL:** "T/R Switches, Baluns, and Detuning Elements in MRI RF coils", PROCEEDINGS OF THE INTERNATIONAL SOCIETY FOR MAGNETIC RESONANCE IN MEDICINE, 14TH ANNUAL MEETING AND EXHIBITION, SEATTLE, WASHINGTON, USA, 6-12 MAY 2006; RF SYSTEMS ENGINEERING SESSION, vol. 14, 22 avril 2006 (2006-04-22), XP055149020,
- **IWASAKI H:** "SELF-DIPLEXING CHARACTERISTICS OF CIRCULARLY POLARIZED N-ELEMENT CIRCULAR ARRAY ANTENNA", ELECTRONICS & COMMUNICATIONS IN JAPAN, PART II - ELECTRONICS, WILEY, HOBOKEN, NJ, US, vol. 77, no. 9, 1 septembre 1994 (1994-09-01), pages 95-104, XP000499594, ISSN: 8756-663X
- **JENS HOFFMANN ET AL:** "Human brain imaging at 9.4 T using a tunable patch antenna for transmission", MAGNETIC RESONANCE IN MEDICINE, vol. 69, no. 5, 15 juin 2012 (2012-06-15), pages 1494-1500, XP055148629, ISSN: 0740-3194, DOI: 10.1002/mrm.24367

## Description

## DOMAINE TECHNIQUE

La présente invention concerne un émetteur-récepteur à polarisation circulaire pour l'Imagerie par Résonance Magnétique (IRM).

Le domaine technique de l'invention est celui des antennes haute fréquence (en anglais « RF coil ») et de leur utilisation dans des appareils de Résonnance Magnétique Nucléaire (en anglais « Nuclear Magnetic Resonance ») pour l'homme ou l'animal.

En Imagerie par Résonance Magnétique (IRM, en anglais « Magnetic Resonance Imaging » ou « MRI »), une antenne est utilisée en transmission pour générer un champ radiofréquence ayant une composante magnétique $B_1$ orthogonale au champ statique $B_0$, capable d'exciter les noyaux des atomes, en particulier ceux de l'hydrogène (pour l'IRM dite du proton) au sein de l'échantillon placé dans l'antenne. Au cours du phénomène de relaxation, un signal radiofréquence ayant également une composante $B_1$ de très faible amplitude est réémis par l'échantillon. Il peut alors être détecté soit par la même antenne commutée à ce moment-là sur la chaîne de réception munie d'amplificateurs à très faible bruit, soit par une autre antenne dédiée. Le champ magnétique statique $B_0$ dans lequel baigne l'échantillon détermine la fréquence du signal qui lui est proportionnelle. Ainsi, elle passe de 64 MHz à 128 MHz pour un champ $B_0$ de 1,5 et 3 teslas respectivement.

Pour les scanners IRM, dits à haut champ, c'est-à-dire dont le champ $B_0$ dépasse 3 teslas, une antenne est généralement composée de plusieurs résonateurs mis en réseau afin d'obtenir, d'une part, une excitation uniforme à travers le procédé de transmission parallèle et, d'autre part, une meilleure sensibilité en réception qui améliore la qualité de l'image. Ces résonateurs émettent et reçoivent les signaux radiofréquences.

L'invention a pour objet un type de résonateur particulièrement adapté à l'exploration, par imagerie ou spectroscopie, d'une région située dans l'axe du champ magnétique $B_0$, notamment le sommet de la tête chez l'homme ou les grands primates.

## ETAT DE LA TECHNIQUE

Le fonctionnement des antennes IRM à haut champ (c'est-à-dire au-delà de 3 teslas) est caractérisé par une inhomogénéité des champs magnétiques radiofréquences émis ou perçus par un seul résonateur : $B_1^+$ en émission et $B_1^-$ en réception. La quantité $B_1^+$ correspond à la polarisation circulaire du champ magnétique tournant dans le même sens que les spins nucléaires utilisés pour l'imagerie. Par opposition, la quantité $B_1^-$ est la polarisation qui tourne en sens inverse et qui caractérise la sensibilité en réception. L'inhomogénéité des champs magnétiques est inhérente aux équations de l'électromagnétisme. Elle augmente avec la fréquence du signal et par conséquent avec le champ magnétique $B_0$.

En émission, l'inhomogénéité de $B_1^+$ se traduit sur une image par l'apparition de zones d'ombre ou de contraste artificiel, difficiles à interpréter. Pour y remédier, une antenne réseau formée par une multitude de résonateurs doit être utilisée, pour uniformiser directement $B_1^+$ ainsi que l'angle de bascule (flip angle en langue anglaise) Cette compensation sera d'autant plus efficace que le nombre de résonateurs dans une antenne réseau sera élevé.

En réception, un plus grand nombre de résonateurs fournira un profil global de réception plus uniforme avec une augmentation du rapport signal sur bruit. Cette augmentation pourra être mise à profit pour accroître la résolution de l'image ou pour diminuer le temps d'acquisition en utilisant une méthode d'accélération qui utilise la sensibilité différentielle entre des résonateurs du fait de leur construction ou répartition autour de l'échantillon.

Classiquement, il existe deux types de résonateurs qui sont utilisés en IRM à haut champ : les résonateurs linéaires (« stripline » en langue anglaise) et les résonateurs circulaires ou boucles (« loop » en langue anglaise).

Lorsque l'échantillon à étudier est une tête humaine, ces résonateurs sont placés autour de celle-ci sur une surface parallèle à l'axe tête-pieds du patient, qui coïncide également avec la direction du champ statique $B_0$. Dans cette configuration, les résonateurs éclairent peu la région du cerveau située au sommet de la tête. Réciproquement, ils reçoivent aussi peu de signal de cette région.

Compte-tenu de la géométrie de la tête et des antennes, une première solution d'amélioration consisterait à placer, au sommet de la tête, un résonateur émetteur-récepteur présentant une forme symétrique par rapport à l'axe tête-pieds, comme par exemple un résonateur-boucle dont la surface du résonateur serait orthogonale à cet axe tête-pieds.

Toutefois, le champ magnétique rayonné par une boucle est essentiellement orthogonal à sa surface. Ainsi, la composante $B_1$ serait essentiellement parallèle à $B_0$, donc inefficace en résonance magnétique. Seule la région proche du conducteur de la boucle présente une composante $B_1$ correctement orientée et efficace. Cette observation a conduit vers une stratégie où un grand nombre de boucles de taille réduite sont utilisées en réseaux à la recherche, d'une part, de l'augmentation de l'effet de bord par l'augmentation de la longueur cumulée des conducteurs formant des boucles et, d'autre part, d'une orientation plus favorable des champs magnétiques rayonnés. Malgré sa pertinence, cette solution présente deux inconvénients majeurs. En premier lieu, la réalisation et le réglage du réseau de boucles sont très complexes. En effet, chaque boucle doit résonner à la fréquence de Larmor, présenter une impédance terminale précise et ne pas se coupler aux boucles voisines afin de ne pas réduire le rendement du réseau en émission ou encore augmenter le bruit corrélé en réception. Ensuite, le réseau ne permet pas d'explorer avec une bonne sensibilité les régions plus profondes du cerveau, notamment au-dessus du thalamus car la profondeur de pénétration du champ rayonné décroit avec la taille des boucles.

Le mouvement de précession des spins induit une polarisation circulaire aux champs magnétiques radiofréquences mis en jeu en IRM. Pour un résonateur donné, le canal qui émet la polarisation $B_1^+$ sera utilisé pour exciter les spins et le canal qui émet la polarisation $B_1^-$ sera utilisé pour recevoir le signal de relaxation en vertu du principe de réciprocité. On entend par canal un port physique par lequel le résonateur est connecté au monde extérieur. Les résonateurs linéaires ou circulaires émettent un champ magnétique polarisé linéairement. Or, une polarisation linéaire est le résultat de la superposition de deux polarisations circulaires tournant en sens inverse, en l'occurrence $B_1^+$ et $B_1^-$. Ainsi, le même canal peut être utilisé alternativement en émission et en réception. Cependant, la moitié de la puissance disponible n'est pas exploitée à chaque fois. Par conséquent, le rendement et la sensibilité en champ du résonateur se trouve réduit de 40% respectivement en émission et en réception.

Une solution particulièrement avantageuse consiste à utiliser un résonateur circulaire de type « patch ». Un tel résonateur a été utilisé en complément d'une antenne réseau pour émettre une polarisation circulaire ([1] Hoffmann, J. et al. (2013), Human Brain Imaging at 9.4 T Using a Tunable Patch Antenna for Transmission. Magnetic Resonance in Medicine, 69: 1494-1500). Typiquement, ce résonateur est constitué d'une surface métallique déposée sur une plaque diélectrique dont la seconde face est recouverte par un plan de masse. Un tel résonateur circulaire est également décrit dans le document : B. Zhang et al., "Design of a Patch Antenna for Creating Traveling Waves at 7 Tesla, vol. 17, 4746, 4 avril 2009, le document G. Shaian et al.. "Rat brain MRI at 16,4T usinq a capacitively tunable patch antenna in combination with a receive array", vol. 25, no. 10, 17 février 2012, le document Y. Pang et al., "MR experiment validation of parallel traveling-wave quadrature patch antenna transceiver array", vol. 19, 1904, 23 avril 2011, le document Y. Pang et al., "Parallel Traveling-wave MRI : Antenna Arrav Approach to Traveling-wave MRI for Parallel Transmission and Acquisition", vol. 18, 17 avril 2010, page 3794 et le document X. Zhang et al., « Single-feed quadrature coils as transceiver array elements for improved SNR and transmit efficiency », vol. 17, 4 avril 2009, page 3014.

Ce type de résonateur est connu et utilisé dans le domaine des antennes radiofréquence pour la communication de données. Le résonateur décrit dans le document WO 2007/14105 nécessite un disque de 320 mm de diamètre en poly-tétra-fluoro-éthylène (PTFE) pour une fréquence de résonance de 400 MHz. Le diamètre de l'élément rayonnant est de 210 mm. L'alimentation est réalisée à travers un coupleur hybride 90° en deux points situés en périphérie de l'élément rayonnant et sur deux axes orthogonaux passant par son centre pour former un canal d'émission. Pour un résonateur « patch », le diamètre du disque est d'autant plus grand que la fréquence de résonance est basse. Ainsi pour une application avec scanner IRM de 7 teslas à 298 MHz, le diamètre de l'élément rayonnant selon l'enseignement de ce document dépasserait 320 mm en conservant le même substrat en PTFE. Un grand diamètre, en dehors de la problématique d'encombrement dans un scanner d'IRM, augmenterait le couplage mutuel vers les résonateurs linéaires ou circulaires qui doivent être placés au plus près de la tête et avec lesquels le résonateur « patch » doit s'intégrer pour former une antenne réseau.

Ainsi pour une application en imagerie médicale, le diamètre extérieur du résonateur « patch » ne devrait pas excéder 180 mm pour que ce dernier puisse être placé à environ 40 mm par rapport au sommet de la tête.

Trois méthodes sont connues pour réduire la taille d'un résonateur « patch ».

Une première méthode consiste à choisir un substrat avec une constante diélectrique nettement plus élevée (typiquement une céramique en alumine) permettant de réduire la longueur d'onde du signal propagé dans le substrat. Celle-ci varie en première approximation comme l'inverse de la racine carré de la constante diélectrique. Toutefois, la réalisation d'un circuit imprimé en céramique est plus difficile et onéreuse par rapport à un substrat en polymère. Elle rend aussi le dispositif plus fragile mécaniquement vis-à-vis des vibrations acoustiques générées par les aimants de gradient dans un scanner IRM.

Une deuxième méthode consistant à aménager des fentes orientées convenablement permet également de réduire la fréquence de résonance pour une géométrie donnée, et par extension, de réduire la taille du résonateur pour une fréquence donnée ([2] Wong, K.-L. and Lin, Y.-F. (1998), Circularly polarised microstrip antenna with a tuning stub. Electronic Letters, Vol. 34, No. 9: 831-832 - [3] Wong Kin-Lu et al. (1998), "Small slot-coupled circularly-polarised microstrip antenna with modified cross-slot and bent tuning-stub", vol. 34, no. 16). Cependant, les fentes telles qu'elles apparaissent dans le document présentent un inconvénient majeur en ce qu'elles réduisent significativement le champ magnétique dans la zone utile en IRM, proche du résonateur et autour de l'axe de symétrie.

Une troisième méthode consiste à monter des condensateurs entre l'élément rayonnant et le plan de masse de manière à réduire la taille d'un résonateur « patch ». Cette méthode est particulièrement décrite dans le document WO 2007/141505. Toutefois, les condensateurs présentent des pertes intrinsèques caractérisées par un facteur de qualité. Ces pertes augmentent proportionnellement à la valeur de la capacité, et inversement proportionnellement au facteur de qualité. En outre, les condensateurs doivent supporter des tensions supérieures à 2000 volts pour une puissance incidente de 1 kW quand le résonateur est utilisé en transmission. Or, parmi les condensateurs industriels disponibles, plus la tension admissible est élevée, plus le facteur de qualité diminue. Les pertes réduisent le rendement et la sensibilité du résonateur, respectivement en émission et en réception. Cette approche n'est donc valable que dans le cas où le rendement et la sensibilité ne sont pas des critères déterminants, comme cela peut être le cas dans le domaine de la RFID (radiofrequency identification en anglais) et comme c'est exactement le cas inverse dans le domaine de l'IRM.

Enfin, toujours dans l'objectif de réduire l'encombrement du résonateur, il est avantageux de trouver une solution pour obtenir un résonateur « patch » sans le recours à un circuit hybride.

La référence [2] propose un résonateur « patch » sans l'utilisation d'un circuit hybride. Le résonateur décrit comporte deux positions possibles de connexion, l'une pour émettre et recevoir une polarisation LHCP et l'autre pour émettre et recevoir une polarisation RHCP . L'utilisation conjointe des deux positions n'a pas été envisagée pour ce résonateur. Mais si les deux positions devaient être connectées simultanément, il y aurait un couplage mutuel fort au niveau des points de connexion en émission et en réception ce qui se traduirait par une perte de puissance, environ 40% de puissance. Un tel résonateur n'est donc pas adapté pour être utilisé dans le domaine de l'imagerie par résonance magnétique nucléaire.

De plus, le résonateur décrit dans la référence [2] présente des moyens de réglages irréversibles pour l'efficacité de la polarisation et la fréquence de fonctionnement. Ceux-ci n'offrent pas la flexibilité nécessaire à un résonateur utilisé dans le domaine de l'imagerie par résonance magnétique nucléaire car ces réglages dépendent de la taille et forme de la tête humaine placé dans son voisinage.

Compte-tenu de toutes ces contraintes et de cet état de l'art, les résonateurs « patch », bien que très répandus en télécommunication, sont encore très peu utilisés dans le domaine de l'IRM. En effet, aucune des solutions décrites n'est satisfaisante pour une application d'Imagerie par Résonance Magnétique (IRM) à très haut champ magnétique.

Ainsi, les solutions proposées ne résolvent ni le problème de taille des « patchs » (car elles nécessitent l'adjonction de composants électriques supplémentaires, ni même le problème de la performance suffisante pour une application en IRM.

## EXPOSE DE L'INVENTION

Dans ce contexte, la présente invention vise à résoudre les problèmes mentionnés précédemment en proposant un résonateur planaire compact, dit résonateur « patch », pour l'Imagerie par Résonance Magnétique et permettant alternativement d'émettre un signal polarisé circulaire gauche (LHCP pour Left Hand Circular Polarisation en langue anglaise) et de recevoir un signal polarisé circulaire droit (RHCP pour Right Hand Circular Polarisation en langue anglaise) aux travers de deux ports radiofréquences distincts.

A cette fin, l'invention propose dans la revendication indépendante 1 un résonateur « patch » pour appareil à résonance magnétique nucléaire comportant : un plan de masse, un élément conducteur, un premier élément diélectrique positionné entre ledit plan de masse et ledit élément conducteur, ledit résonateur étant apte à émettre un signal radiofréquence polarisé circulairement lorsque le résonateur est alimenté par une première ligne de transmission connectée audit élément conducteur au moyen d'un premier point de connexion et apte à recevoir alternativement un signal radiofréquence polarisé circulairement de sens opposé lorsque le résonateur est connecté à une deuxième ligne de transmission via un deuxième point de connexion, ledit résonateur comportant sur chaque ligne de transmission un moyen de commutation monté en parallèle à une distance du plan de masse correspondant à $(2n + 1)\lambda/4$ avec $n$ un nombre entier naturel, et $\lambda$ la longueur d'onde de l'onde guidée dans la ligne de transmission à la fréquence de fonctionnement du résonateur, lesdits moyens de commutation permettant de connecter/déconnecter lesdites lignes de transmission.

Ainsi, l'invention concerne un résonateur planaire compact pour l'émission et la réception d'un signal radiofréquence à polarisation circulaire compact de dimensions inférieures ou égales à $\lambda_0/5$, où $\lambda_0$ est la longueur d'onde du signal propagé dans l'air. Le résonateur selon l'invention comporte un moyen de commutation actif, avantageusement formé par des diodes PIN, permettant alternativement d'émettre un signal polarisé circulaire LHCP et de recevoir un signal polarisé RHCP aux travers de deux ports radiofréquences distincts, en faisant l'économie d'un circuit hybride 90° pour réduire au maximum l'encombrement d'un tel résonateur.

Le résonateur « patch » selon l'invention peut également présenter une ou plusieurs des caractéristiques ci-dessous, considérées individuellement ou selon toutes les combinaisons techniquement possibles :

-   ledit moyen de commutation est une diode PIN présentant un état bloqué et un état passant, ladite diode PIN associée à la première ligne de transmission étant bloquée en émission et passante en réception, ladite diode PIN associée à la deuxième ligne de transmission de réception étant passante en émission et bloquée en réception ;

-   ledit résonateur présente un blindage ; le blindage permet ainsi d'éviter le couplage mutuel avec des résonateurs linéaires ou circulaires qui doivent être placés au plus près de la tête et avec lesquels le résonateur « patch » doit s'intégrer pour former une antenne réseau ;

- ledit résonateur présente un premier blindage supérieur et un deuxième blindage latéral au niveau de la tranche dudit résonateur ;

- ledit résonateur est tel que le plan de masse couvre la face inférieure du premier élément diélectrique, et ledit résonateur présente :

  - un deuxième élément diélectrique positionné au-dessus dudit premier élément diélectrique et de l'élément conducteur ;
  - un premier blindage supérieur positionné sur la face supérieure dudit deuxième élément diélectrique ;
  - un deuxième blindage latéral au niveau de la tranche dudit résonateur ;

- ledit résonateur comporte quatre condensateurs variables permettant de régler la fréquence de fonctionnement du résonateur et/ou de régler l'impédance au niveau du premier point de connexion et du deuxième point de connexion à la fréquence de fonctionnement du résonateur, et/ou de régler l'efficacité des polarisations circulaires ; avantageusement les quatre variables sont de très faibles valeurs et présentent donc une dissipation en puissance très limitée, et permettent de régler indépendamment les trois paramètres importants pour le fonctionnement du résonateur en IRM ;

- le résonateur comporte quatre appendices disposés autour de l'élément conducteur et reliés électriquement au dit élément conducteur formant un transformateur d'impédance en ligne triplaque ; les appendices positionnés en périphérie jouant le rôle d'un transformateur d'impédance en topologie de ligne triplaque ramènent avantageusement un effet capacitif, quasiment sans dissipation de puissance, en assurant une excellente tenue en tension ;

- ledit élément conducteur a la forme d'un disque et présente une pluralité de fentes radiales, chacune des fentes radiales s'étendant du bord du disque conducteur jusqu'à une distance donnée du centre du disque conducteur ;

- le résonateur comporte huit fentes ;

- les deux points de connexions sont positionnés à la surface du disque conducteur sur deux droites orthogonales, dites axes principaux, se coupant au centre du disque conducteur, les deux points étant à une distance identique du centre du disque conducteur ;

- le résonateur comporte quatre condensateurs variables, lesdits condensateurs variables étant positionnés selon de deux droites orthogonales, dites axes secondaires, les axes secondaires présentant un décalage angulaire de 45° par rapport aux axes principaux ;

- lesdits condensateurs variables sont positionnés aux intersections des bords externes des appendices et des deux axes secondaires.

L'invention a également pour objet une antenne haute fréquence pour appareil à résonance magnétique nucléaire caractérisée en ce qu'elle comporte un résonateur « patch » selon l'invention.

Avantageusement l'antenne haute fréquence pour appareil à résonance magnétique nucléaire est une antenne à voies multiples comportant une pluralité de résonateurs linéaires présentant un élément rayonnant rectiligne et/ou une pluralité de résonateurs boucles comportant un élément rayonnant formant une boucle, lesdits éléments rayonnants étant utilisés pour émettre un signal radiofréquence d'excitation et/ou pour recevoir un signal radiofréquence de relaxation.

## BREVES DESCRIPTIONS DES FIGURES

D'autres caractéristiques et avantages de l'invention ressortiront plus clairement de la description qui en est donnée ci-dessous, à titre indicatif et nullement limitatif, en référence aux figures annexées, parmi lesquelles :

- les figures 1 à 3 illustrent différentes vues en perspective d'un résonateur « patch » selon l'invention ;
- la figure 4 illustre une vue en coupe radiale passant par un point de connexion du résonateur « patch » selon l'invention illustré aux figures 1 à 3 ;
- la figure 5 illustre schématiquement un circuit de commutation du résonateur « patch » selon l'invention ;
- la figure 6 est une illustration d'un abaque de Smith ;
- les figures 7a à 7c sont des représentations de différents limaçons de Pascal.

## DESCRIPTION D'AU MOINS UN MODE DE REALISATION

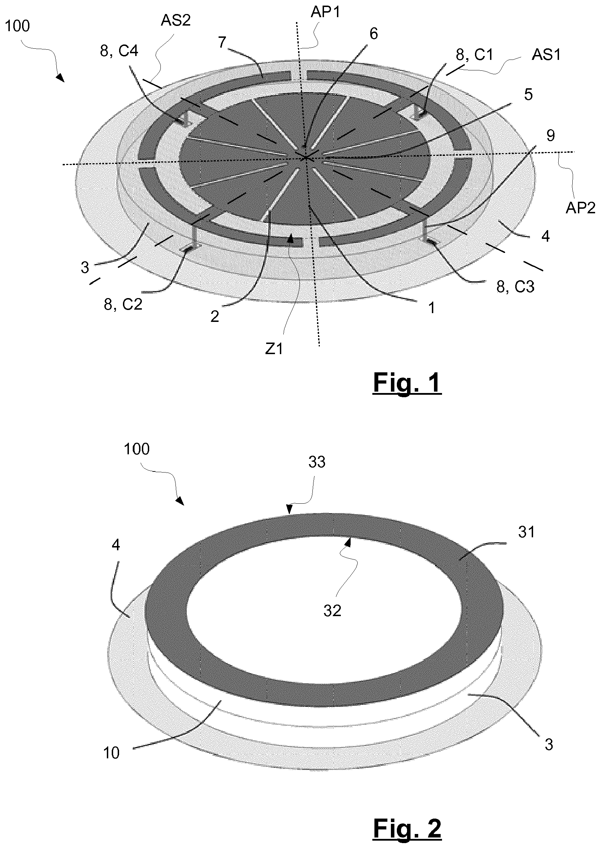

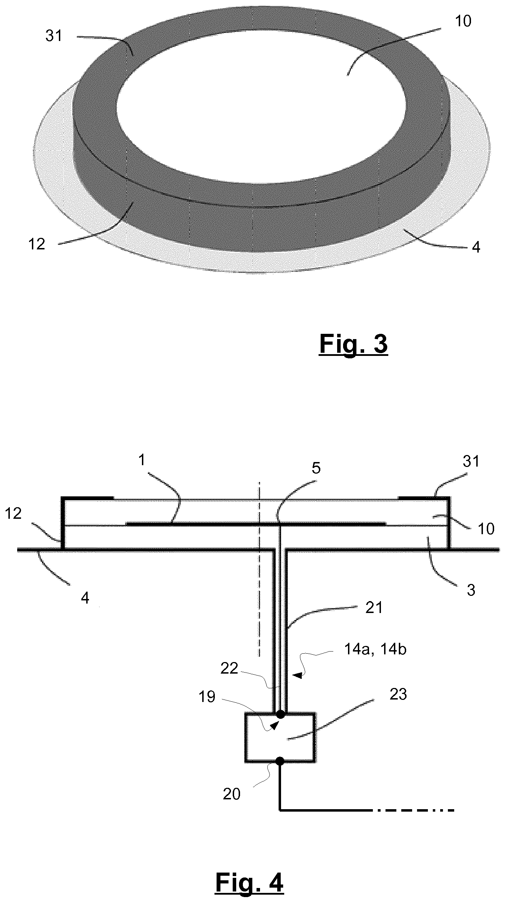

Les figures 1 à 3 représentent schématiquement un résonateur circulaire 100, appelé résonateur « patch », selon l'invention utilisable en émission et en réception pour l'Imagerie par Résonance Magnétique (IRM). La figure 4 représente une vue en coupe radiale du résonateur circulaire 100 illustré au figures 1 à 3 montrant les détails des connexions.

Les figures 1 à 4 seront décrites conjointement.

Le résonateur « patch » 100 selon l'invention comporte :

- un disque conducteur 1 ;
- un disque en matériau diélectrique appelé substrat inférieur 3, sur lequel le disque conducteur 1 est fixé ;
- un plan de masse 4 couvrant la face inférieure du substrat inférieur 3 ;
- deux points de connexion 5 et 6, chacun reliant électriquement le disque conducteur 1 à l'âme centrale 22 d'une ligne de transmission formée par un câble coaxial 14a, 14b dont le conducteur externe 21 est relié électriquement au plan de masse 4 ;
- quatre appendices 7 en forme d'arc de cercle reliés électriquement en leur milieu au disque conducteur 1 et positionnés à la périphérie du disque conducteur 1 ;
- quatre condensateurs variables 8 de faible valeur, typiquement de 0,5 à 2 pF, un pour chaque appendices 7, permettant le réglage du résonateur 100 en adaptation d'impédance, fréquence de fonctionnement, et rendement des polarisations circulaires.

Le disque conducteur 1 est avantageusement réalisé en cuivre et présente une épaisseur correspondant à environ six fois l'épaisseur de peau (pénétration de l'onde électromagnétique dans le conducteur) à la fréquence de fonctionnement du résonateur.

Avantageusement, le disque conducteur 1 présente des découpes orientées radialement formant des fentes 2. La présence des fentes 2 sur le disque conducteur 1, avantageusement au nombre de huit, permet de réduire la fréquence de résonance du résonateur 100 pour une géométrie donnée. Par conséquent, ces fentes 2 permettent de réduire la taille du disque conducteur 1, et donc son encombrement, pour la fréquence d'utilisation souhaitée en IRM, et notamment pour une fréquence de 298MHz correspondant à la fréquence de résonance magnétique nucléaire des protons à 7 Teslas (T).

Selon un mode de réalisation privilégié de l'invention, les fentes 2 ne traversent pas le centre du disque conducteur 1 de manière à améliorer le rendement du résonateur 100, notamment dans le domaine de l'IRM où le résonateur fonctionne en champ proche. Avantageusement, les fentes 2 s'étendent radialement jusqu'au bord du disque conducteur 1, de manière à éviter l'apparition de courants induits par les aimants de gradient pulsés des appareils de Résonnance Magnétique Nucléaire.

Le disque formant le substrat inférieur 3 présente un diamètre plus grand que le diamètre du disque conducteur 1 sur lequel il repose. Avantageusement, son épaisseur est choisie de manière à obtenir un bon compris entre le rayonnement et la stabilité du réglage de la fréquence. Avantageusement, l'épaisseur du substrat inférieur 3 est comprise entre 1/10e et 1/4e du diamètre du disque conducteur 1, et préférentiellement de l'ordre de 1/5e du diamètre du disque conducteur 1. Préférentiellement, le substrat inférieur 3 est réalisé dans un matériau à très faible perte diélectrique.

Les points de connexion 5 et 6 sont placés sur le disque conducteur 1 et positionnés selon deux droites orthogonales, appelées par la suite axes principaux AP1 et AP2, se coupant au centre du disque conducteur 1. Les deux points de connexions 5 et 6 sont positionnés à une distance égale du centre du disque conducteur 1.

Les appendices 7 positionnés autour du disque conducteur 1 ont un rôle de transformateur d'impédance pour ramener un effet capacitif. Ils remplacent donc avantageusement des condensateurs utilisés dans les résonateurs « patchs » selon l'état de la technique pour diminuer leur encombrement et qui sont une source de perte de rendement et de sensibilité du résonateur.

Les condensateurs variables 8 sont connectés électriquement d'une part sur des puits conducteurs 9 traversant le substrat inférieur 3 et reliés aux appendices 7 et d'autre part sur le plan de masse 4. Les condensateurs variables 8 sont positionnés le long de deux droites orthogonales, appelées axes secondaires AS1 et AS2. Les axes secondaires sont dans le même plan que celui formé par les axes principaux AP1, AP2 et présentent un décalage angulaire de 45° par rapport aux axes principaux AP1 et AP2.

Selon un mode de réalisation avantageux de l'invention, et pour diminuer davantage les dimensions du résonateur par la diminution des dimensions des appendices 7 tout en conservant un même effet capacitif, un second disque en matériau diélectrique, appelé substrat supérieur 10 et un blindage coronaire 31 sont ajoutés au résonateur. Les diamètres, les épaisseurs et les matières des deux substrats, inférieur 3 et supérieur 10, sont préférentiellement identiques.

Le blindage coronaire 31 supplémentaire est positionné sur la face supérieure du substrat supérieur 10. Le rayon interne 32 de la couronne formée par le blindage coronaire 31 est adapté en fonction du compromis souhaité entre le rendement de polarisation circulaire et le couplage mutuel du résonateur « patch » 100 avec d'autres résonateurs présents dans le voisinage, comme par exemple dans une antenne réseau. Ainsi, plus le rayon interne 32 du blindage coronaire 31 est faible, plus la surface du blindage sera importante, ce qui permet de minimiser le couplage mutuel avec d'autres résonateurs mais réduit également le rendement du résonateur 100 du fait de l'effet d'écrantage. En pratique, et de façon avantageuse, pour une application à 7T, ce rayon interne 32 se situera entre le rayon externe du disque conducteur 1 et le rayon interne formé par les appendices 7, i.e. dans la zone Z1 hachurée sur la figure 1.

Le résonateur 100 comporte également un blindage latéral 12 illustré à la figure 3 complétant le blindage coronaire supérieur 31. Le blindage latéral 12 permet également de réduire le couplage mutuel. Ainsi, l'utilisation des deux blindages 12 et 31 permet de minimiser de façon optimale le couplage mutuel. Toutefois, il est possible d'utiliser seul le blindage coronaire supérieur 31 uniquement pour réduire l'encombrement des appendices 7.

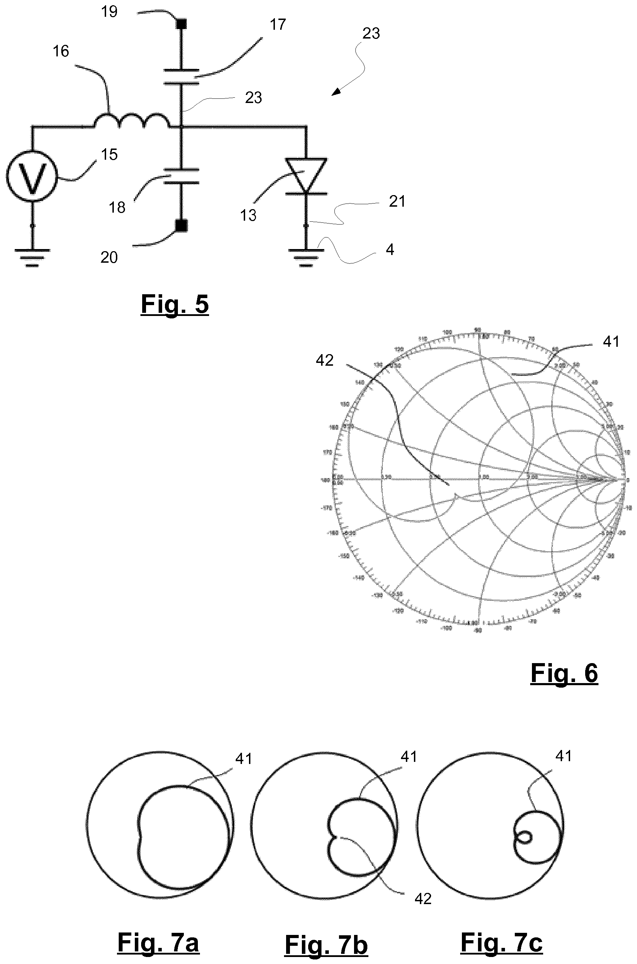

Pour utiliser un même résonateur « patch » alternativement en émission et en réception respectivement en polarisation circulaire gauche (LHCP pour Left Hand Circular Polarisation en langue anglaise) et polarisation circulaire droite (RHCP pour Right Hand Circular Polarisation en langue anglaise) sans perte d'efficacité ou de rendement, le résonateur 100 selon l'invention comporte un circuit de commutation 23, illustré plus particulièrement à la figure 5, composé d'une diode PIN 13 (pour Positive Intrinsic Negative en langue anglaise) relié à chaque point de connexion 5 et 6. Chaque diode PIN 13 est connectée en parallèle sur chaque câble coaxial 14a, 14b à une distance égale à $(2n + 1)\lambda/4$ du plan de masse 4, avec $n$ entier naturel, et $\lambda$ la longueur d'onde dans le câble coaxial à la fréquence de fonctionnement. De façon plus générale, le circuit de commutation 23 doit être composé d'un élément de commutation qui doit être :

- rapide ; c'est à dire au moins d'un facteur dix plus faible que le temps de relaxation des atomes (par exemple 10 microsecondes pour des protons dont le temps de relaxation est de 100 microsecondes) ;
- apte à supporter la puissance radiofréquence en général de quelques kilowatts à quelques dizaines de kilowatts.

Les figures 4 et 5 montrent respectivement les détails des connexions et les détails du circuit de commutation 23. Il faut noter que les schémas présentés sont tout aussi valables pour le câble d'émission que pour le câble de réception des points de connexion.

La figure 4 représente une coupe radiale passant par un point de connexion 5 ou 6. La figure 5 montre la composition du circuit de commutation 23 entre les deux ports d'interface 19, du côté de la ligne coaxiale 14a, 14b, et 20 du côté du scanner IRM. Au-delà du port d'interface 20, le circuit électronique d'émission ou de réception est classique, et est composé au moins d'une source radiofréquence de puissance en émission et d'un préamplificateur faible bruit en réception. Ces éléments étant connus ils ne seront pas détaillés dans la présente demande.

Chaque diode PIN 13 est pilotée indépendamment par un générateur de tension 15. Ainsi, pour une polarité positive, par exemple +10 Volts, la diode PIN 13 est dite passante; elle se comporte donc électriquement comme une résistance de très faible valeur voisine de 0.5 ohm (presque un court-circuit). Par conséquent, l'impédance ramenée au niveau du plan de masse 4 par l'intermédiaire du câble coaxial 14a, 14b est alors de façon connue, voisine de 5 kohms si le câble coaxial présente une impédance caractéristique de 50 ohms. Dans ces conditions, tout se passe comme si le point de connexion associé n'existait pas physiquement. En revanche, si la polarité du générateur 15 est négative, par exemple -30 Volts, la diode PIN 13 sera dite bloquée. Elle se comporte alors électriquement comme un condensateur de très faible valeur (typiquement 0.7 pF) mis en parallèle avec une résistance de forte valeur (typiquement 200 kohms). Dans le domaine des ondes électromagnétiques très hautes fréquences de type VHF (pour Very High Frequency en langue anglaise) et UHF (Ultra High Frequency en langue anglaise), tout se passe comme si la diode PIN 13 n'existait pas. Ainsi, pour émettre sur le port connecté au point de connexion 5, la diode PIN 13 associée est pilotée avec une polarité négative et la seconde diode PIN 13 connectée au point de connexion 6 est pilotée avec une polarité positive simultanément. En réception sur le port connecté au point 6, il suffit d'inverser la polarité des deux générateurs 15.

Chaque générateur de pilotage 15 est protégé des courants hautes-fréquences par une inductance de choc 16, typiquement de l'ordre de 10 $\mu$H. Inversement, les circuits hautes-fréquences sont isolés du courant continu du générateur de pilotage 15 par deux condensateurs 17 et 18.

## EXEMPLE DE REALISATION ET MISE EN OEUVRE

Un exemple de réalisation est donné pour la construction et le réglage d'un résonateur « patch » 100 selon l'invention fonctionnant à une fréquence de 298 MHz, fréquence correspondant à la fréquence de résonance magnétique nucléaire des protons à 7 Teslas.

Ainsi, le disque conducteur 1, avec ses fentes 2 et ses appendices 7 sont gravés par la technique des circuits imprimés sur un stratifié à double couche de cuivre. La deuxième couche de cuivre est utilisée pour former le plan de masse 4. Ce stratifié forme également le substrat inférieur 3. Les points de connexion 5 et 6 sont obtenus par la réalisation de trous métallisés, généralement appelés vias, qui relient les deux faces du substrat inférieur 3. Ces vias forment les puits conducteurs 9.

Avantageusement, le même stratifié à double couche est aussi utilisé pour réaliser le blindage coronaire 31 et le substrat supérieur 10, sauf que sur celui-ci la seconde couche de cuivre est entièrement retirée. Les deux stratifiés sont ensuite thermocollés par un film en polyoléfine. Le blindage latéral 12 peut être constitué par un ruban adhésif en cuivre, de l'ordre de 80 $\mu$m d'épaisseur, collé sur la tranche du résonateur. Des points de soudure sont réalisés de manière à assurer la liaison électrique entre le blindage coronaire 31 dans la partie supérieure du résonateur 100 et le plan de masse 4 dans la partie inférieure du résonateur 100. Le diamètre du disque conducteur 1 et des substrats 3 et 10 sont respectivement de 120 mm et 180 mm.

La réalisation du résonateur 100 selon l'invention nécessite un choix approprié des dimensions des appendices 7 et des fentes 2, afin de réduire autant que possible la valeur des condensateurs variables 8 et donc de minimiser les pertes. Si les appendices 7 sont trop courts, les valeurs des condensateurs seront trop faibles. Si les appendices sont trop longs, les condensateurs seront trop encombrants. La valeur de la capacité ramenée par un appendice de longueur $2L_a$ s'exprime approximativement par la relation :

$$C \approx \frac{2}{\omega Z_0} \tan \beta L_a$$

où $Z_0$ et $\beta$ sont respectivement l'impédance caractéristique et la constante de propagation de la ligne triplaque formée par le blindage coronaire 31, l'appendice 7 et le plan de masse 4. Pour un appendice caractérisé par un rayon interne de 70 mm, un rayon externe de 80 mm et une longueur de 110 mm, la capacité équivalente ramenée est d'environ 7 pF.

Le disque conducteur 1 comporte huit fentes 2 qui permettent de réduire les dimensions du résonateur 100. Les fentes radiales 2 s'alignent sur les bissectrices formées entre un axe primaire AP1, AP2 et un axe secondaire AS1, AS2. Elles débutent à 10 mm du centre du disque conducteur 1 et s'étendent jusqu'au bord de ce dernier. La largeur des fentes est typiquement de 2 mm.

Les points de connexion 5 et 6 sont disposés à 11,5 mm du centre du disque conducteur 1. Cette position est choisie pour obtenir une adaptation en impédance grossière par rapport à un câble coaxial d'impédance caractéristique de 50 ohms.

Avec les dispositions décrites précédemment, une valeur maximale de 1 pF pour les condensateurs variables 8 suffit pour réaliser une adaptation en impédance fine des points de connexion 5 et 6, optimiser la fréquence de fonctionnement à 298 MHz et maximiser l'efficacité d'une des polarisations circulaires. La méthode de réglage est détaillée dans la suite.

Pour un usage de l'invention en imagerie par résonnance magnétique, il est nécessaire que le plan du disque conducteur 1 soit normal au champ magnétique statique $B_0$ de l'aimant principal. Selon le sens de $B_0$, orienté du plan de masse 4 vers le disque conducteur 1 ou l'inverse, le point de connexion 5 sera utilisé pour l'émission et le point de connexion 6 pour la réception ou inversement.

Le réglage du résonateur « patch » 100 selon l'invention se fait grâce aux 4 condensateurs variables 8 visibles à la figure 1. Chaque condensateur présente une valeur courante notée : C1, C2, C3 et C4. Les 4 condensateurs variables 8 permettent de régler trois paramètres :

-    l'impédance présentée par les points de connexion aux câbles coaxiaux,
-    la fréquence de fonctionnement,
-    l'efficacité ou rendement des polarisations circulaires.

L'impédance du résonateur « patch » 100 diminue lorsqu'on augmente C1 tout en diminuant simultanément C2 et en conservant une valeur identique pour C3 et C4. La fréquence de fonctionnement augmente lorsqu'on diminue la somme C1+C2+C3+C4. L'efficacité de la polarisation circulaire désirée varie lorsqu'on fait varier le ratio (C1+C2)/(C3+C4). L'efficacité ou le rendement d'une polarisation s'évalue expérimentalement ou en simulation par la valeur moyenne du champ $B_1^+$ dans la région de l'échantillon située en regard du disque conducteur 1.

Le réglage de l'impédance se fait de façon connue grâce à la représentation du coefficient de réflexion en fonction de la fréquence. Il vise à minimiser la valeur de ce coefficient à la fréquence de fonctionnement du résonateur 100.

Le réglage de l'efficacité de l'antenne s'appuie sur la représentation du coefficient de réflexion dans un abaque de Smith, tel qu'illustré à la figure 6, c'est-à-dire une représentation dans le plan complexe de ce coefficient pour une variation linéaire de la fréquence. Dans le cas général, le tracé 41 présente une forme résultant d'une rotation et d'une translation appliquées à une courbe dite en limaçon de Pascal, illustrée aux figures 7a à 7c, d'équation générale $r = a + b \times \cos(\theta)$, où $r$ est le rayon au centre de l'abaque, $\theta$ l'angle, avec a et b des paramètres dépendant des caractéristiques du résonateur et de son réglage.

Le réglage optimal correspond à celui où le limaçon de Pascal dégénère en cardioïde, figure 7b, en faisant apparaître un point double 42 dont la fréquence associée sera la fréquence de fonctionnement.

Dans l'exemple de réalisation, les valeurs optimales des condensateurs C1 à C4 sont de 0,7 pF, 0,9 pF, 0,8 pF et 0,8 pF respectivement.

**Revendications**

1.    Résonateur patch (100) pour appareil à résonance magnétique nucléaire comportant : un plan de masse (4), un élément conducteur (1), un premier élément diélectrique (3) positionné entre ledit plan de masse (4) et ledit élément conducteur (1), ledit résonateur (100) étant apte à émettre un signal radiofréquence polarisé circulairement lorsque le résonateur est alimenté par une première ligne de transmission (14a) connectée audit élément conducteur (1) au moyen d'un premier point de connexion (5) et apte à recevoir alternativement un signal radiofréquence polarisé circulairement de sens opposé lorsque le résonateur est connecté à une deuxième ligne de transmission (14b) via un deuxième point de connexion (6), ledit résonateur comportant sur chaque ligne de transmission (14a, 14b) un moyen de commutation (13) monté en parallèle à une distance du plan de masse (4) correspondant à $(2n + 1)\lambda/4$ avec $n$ un nombre entier naturel, et $\lambda$ la longueur d'onde de l'onde guidée dans la ligne de transmission (14a, 14b) à la fréquence de fonctionnement du résonateur, lesdits moyens de commutation (13) permettant de connecter/déconnecter électriquement lesdites lignes de transmission (14a, 14b) dudit élément conducteur.

**2.** Résonateur patch (100) pour appareil à résonance magnétique nucléaire selon la revendication précédente **caractérisé en ce que** ledit moyen de commutation est une diode PIN présentant un état bloqué et un état passant, ladite diode PIN associée à la première ligne de transmission (14a) étant bloquée en émission et passante en réception, ladite diode PIN associée à la deuxième ligne de transmission (14b) de réception étant passante en émission et bloquée en réception.

**3.** Résonateur patch (100) pour appareil à résonance magnétique nucléaire selon l'une des revendications précédentes **caractérisé en ce que** ledit résonateur présente un blindage (31, 12).

**4.** Résonateur patch (100) pour appareil à résonance magnétique nucléaire selon la revendication 1 ou **caractérisé en ce que** ledit résonateur présente un premier blindage supérieur (31) et un deuxième blindage latéral (12) au niveau de la tranche dudit résonateur (100).

**5.** Résonateur patch (100) pour appareil à résonance magnétique nucléaire selon la revendication 1 ou 2 **caractérisé en ce que** ledit plan de masse (4) couvre la face inférieure du premier élément diélectrique (3) ;
et ledit résonateur présente :

   - un deuxième élément diélectrique (10) positionné au-dessus dudit premier élément diélectrique (3) et de l'élément conducteur (1) ;
   - un premier blindage supérieur (31) positionné sur la face supérieure dudit deuxième élément diélectrique (10) ;
   - un deuxième blindage latéral (12) au niveau de la tranche dudit résonateur (100).

**6.** Résonateur patch (100) pour appareil à résonance magnétique nucléaire selon l'une des revendications précédentes **caractérisé en ce que** ledit résonateur comporte quatre condensateurs variables (8) permettant de régler la fréquence de fonctionnement du résonateur (100) et/ou de régler l'impédance au niveau du premier point de connexion (5) et du deuxième point de connexion (6) à la fréquence de fonctionnement du résonateur (100), et/ou de régler l'efficacité des polarisations circulaires.

**7.** Résonateur patch (100) pour appareil à résonance magnétique nucléaire selon l'une des revendications précédentes **caractérisé en ce que** ledit élément conducteur (1) a la forme d'un disque et présente une pluralité de fentes radiales (2), chacune des fentes radiales (2) s'étendant du bord du disque conducteur (1) jusqu'à une distance donnée du centre du disque conducteur (1).

**8.** Résonateur patch (100) pour appareil à résonance magnétique nucléaire selon la revendication précédente **caractérisé en ce que** le résonateur comporte huit fentes (2).

**9.** Résonateur patch (100) pour appareil à résonance magnétique nucléaire selon l'une des revendications 7 à 8 **caractérisé en ce que** les deux points de connexions (5) et (6) sont positionnés à la surface du disque conducteur (1) sur deux droites orthogonales (AP1, AP2), dites axes principaux, se coupant au centre du disque conducteur, les deux points (5) et (6) étant à une distance identique du centre du disque conducteur (1).

**10.** Résonateur patch (100) pour appareil à résonance magnétique nucléaire selon l'une des revendications précédentes **caractérisé en ce qu'**il comporte quatre appendices (7) disposés autour de l'élément conducteur (1) et reliés électriquement au dit élément conducteur (1) formant un transformateur d'impédance en ligne triplaque.

**11.** Résonateur patch (100) pour appareil à résonance magnétique nucléaire selon la revendication 9 **caractérisé en ce que** ledit résonateur comporte quatre condensateurs variables (8), lesdits condensateurs variables (8) étant positionnés selon deux droites orthogonales (AS1, AS2), dites axes secondaires, les axes secondaires (AS1, AS2) présentant un décalage angulaire de 45° par rapport aux axes principaux (AP1, AP2).

**12.** Résonateur patch (100) pour appareil à résonance magnétique nucléaire selon les revendications 10 et 11 **caractérisé en ce que** lesdits condensateurs variables (8) sont positionnés aux intersections des bords externes des appendices (7) et des deux axes secondaires (AS1, AS2).

**13.** Antenne haute fréquence pour appareil à résonance magnétique nucléaire **caractérisée en ce qu'**elle comporte un résonateur patch (100) selon l'une des revendications précédentes.

**14.** Antenne haute fréquence pour appareil à résonance magnétique nucléaire selon la revendication précédente **caractérisée en ce que** l'antenne est une antenne à voies multiples comportant une pluralité de résonateurs linéaires présentant un élément rayonnant rectiligne et/ou une pluralité de résonateurs boucles comportant un élément rayonnant formant une boucle, lesdits éléments rayonnants étant utilisés pour émettre un signal radiofréquence d'excitation et/ou pour recevoir un signal radiofréquence de relaxation.

**Patentansprüche**

1. Resonator-Patch (100) für Gerät mit kernmagnetischer Resonanz, umfassend: eine Massenebene (4), ein leitendes Element (1), ein erstes dielektrisches Element (3), das zwischen der genannten Massenebene (4) und dem genannten leitenden Element (1) positioniert ist, wobei der genannte Resonator (100) geeignet ist, ein polarisiertes FunkfrequenzSignal kreisförmig auszugeben, wenn der Resonator durch eine erste Übertragungsleitung (14a) versorgt ist, der an das genannte leitende Element (1) mittels eines ersten Anschlusspunktes (5) angeschlossen und geeignet ist, alternativ ein polarisiertes Funkfrequenzsignal kreisförmig in entgegengesetzter Richtung zu empfangen, wenn der Resonator an eine zweite Übertragungsleitung (14b) über einen zweiten Anschlusspunkt (6) angeschlossen ist, wobei der genannte Resonator auf jeder Übertragungsleitung (14a, 14b) ein Umschaltmittel (13) umfasst, das parallel in einer Entfernung zur Massenebene (4) montiert ist, die $(2n + 1)\lambda/4$ entspricht, wobei $n$ eine natürliche ganze Zahl ist, und $\lambda$ die Wellenlänge der geführten Welle in der Übertragungsleitung (14a, 14b) in der Betriebsfrequenz des Resonators ist, wobei die genannten Umschaltmittel (13) das elektrische Anschließen / Abhängen der genannten Übertragungsleitungen (14a, 14b) des genannten leitenden Elements zulassen.

2. Resonator-Patch (100) für Gerät mit kernmagnetischer Resonanz gemäß dem voranstehenden Anspruch, **dadurch gekennzeichnet, dass** das genannte Umschaltmittel eine Diode PIN ist, die einen gesperrten Zustand und einen durchlässigen Zustand aufweist, wobei die genannte Diode PIN, die der ersten Übertragungsleitung (14a) zugeordnet ist, bei der Übertragung gesperrt und beim Empfang durchlässig ist, wobei die genannte Diode PIN, die der zweiten Übertragungsleitung (14b) zugeordnet ist, bei der Übertragung durchlässig und beim Empfang gesperrt ist.

3. Resonator-Patch (100) für Gerät mit kernmagnetischer Resonanz gemäß einem der voranstehenden Ansprüche, **dadurch gekennzeichnet, dass** der genannte Resonator eine Abschirmung (31, 12) aufweist.

4. Resonator-Patch (100) für Gerät mit kernmagnetischer Resonanz gemäß Anspruch 1 oder 2, **dadurch gekennzeichnet, dass** der genannte Resonator eine erste obere Abschirmung (31) und eine zweite laterale Abschirmung (12) an dem Wafer des genannten Resonators (100) aufweist.

5. Resonator-Patch (100) für Gerät mit kernmagnetischer Resonanz gemäß Anspruch 1 oder 2, **da-**
**durch gekennzeichnet, dass** die genannte Massenebene (4) die untere Seite des ersten dielektrischen Elements (3) abdeckt; und der genannte Resonator aufweist:

- ein zweites dielektrisches Element (10), das oberhalb des genannten ersten dielektrischen Elements (3) und des leitenden Elements (1) positioniert ist;
- eine erste obere Abschirmung (31), die auf der oberen Seite des genannten dielektrischen Elements (10) positioniert ist;
- eine zweite laterale Abschirmung (12) an dem Wafer des genannten Resonators (100).

6. Resonator-Patch (100) für Gerät mit kernmagnetischer Resonanz gemäß einem der voranstehenden Ansprüche, **dadurch gekennzeichnet, dass** der genannte Resonator vier variable Kondensatoren (8) umfasst, die das Einstellen der Betriebsfrequenz des Resonators (100) und / oder das Einstellen der Impedanz an dem ersten Anschlusspunkt (5) und dem zweiten Anschlusspunkt (6) auf die Betriebsfrequenz des Resonators (100) und / oder die Einstellung der Effizienz der kreisförmigen Polarisationen zulassen.

7. Resonator-Patch (100) für Gerät mit kernmagnetischer Resonanz gemäß einem der voranstehenden Ansprüche, **dadurch gekennzeichnet, dass** das genannte leitende Element (1) die Form einer Scheibe hat und eine Vielzahl von radialen Schlitzen (2) aufweist, wobei jeder der radialen Schlitze (2) sich vom Rand der leitenden Scheibe (1) bis zu einer bestimmten Entfernung des Zentrums der leitenden Scheibe (1) erstreckt.

8. Resonator-Patch (100) für Gerät mit kernmagnetischer Resonanz gemäß dem voranstehenden Anspruch, **dadurch gekennzeichnet, dass** der Resonator acht Schlitze (2) umfasst.

9. Resonator-Patch (100) für Gerät mit kernmagnetischer Resonanz gemäß einem der Ansprüche 7 bis 8, **dadurch gekennzeichnet, dass** die zwei Anschlusspunkte (5) und (6) an der Oberfläche der leitenden Scheibe (1) auf zwei orthogonalen Geraden (AP1, AP2), bezeichnet als Hauptachsen, positioniert sind, die sich im Zentrum der leitenden Scheibe schneiden, wobei die beiden Punkte (5) und (6) in einer identischen Entfernung vom Zentrum der leitenden Scheibe (1) sind.

10. Resonator-Patch (100) für Gerät mit kernmagnetischer Resonanz gemäß einem der voranstehenden Ansprüche, **dadurch gekennzeichnet, dass** er vier Anhänge (7) umfasst, die um das leitende Element (1) angeordnet und elektrisch mit dem leitenden Element (1) verbunden sind, das einen Impedanztransformator in Leiterbahn formt.

11. Resonator-Patch (100) für Gerät mit kernmagnetischer Resonanz gemäß Anspruch 9, **dadurch gekennzeichnet, dass** der genannte Resonator vier variable Kondensatoren (8) umfasst, wobei die genannten variablen Kondensatoren (8) gemäß zwei orthogonalen Geraden (AS1, AS2), bezeichnet als sekundäre Achsen, positioniert sind, wobei die sekundären Achsen (AS1, AS2) eine Winkelverschiebung von 45° im Verhältnis zu den Hauptachsen (AP1, AP2) aufweisen.

12. Resonator-Patch (100) für Gerät mit kernmagnetischer Resonanz gemäß den Ansprüchen 10 und 11, **dadurch gekennzeichnet, dass** die genannten variablen Kondensatoren (8) an den Knotenpunkten der äußeren Ränder der Anhänge (7) und den zwei sekundären Achsen (AS1, AS2) positioniert sind.

13. Hochfrequenzantenne für kernmagnetisches Resonanzgerät, **dadurch gekennzeichnet, dass** sie einen Resonator-Patch (100) gemäß einem der voranstehenden Ansprüche umfasst.

14. Hochfrequenzantenne für kernmagnetisches Resonanzgerät gemäß dem voranstehenden Anspruch, **dadurch gekennzeichnet, dass** die Antenne eine Mehrwege-Antenne ist, die eine Vielzahl von linearen Resonatoren umfasst, die ein geradliniges strahlendes Element und / oder eine Vielzahl von Schleifenresonatoren aufweist, die ein strahlendes Element umfassen, das eine Schleife formt, wobei die genannten strahlenden Elemente zum Ausgeben eines Funkfrequenz-Erregungssignals und / oder zum Empfangen eines Entspannungs-Funkfrequenzsignals verwendet sind.

## Claims

1. Patch resonator (100) for nuclear magnetic resonance device comprising: a ground plane (4), a conductive element (1), a first dielectric element (3) positioned between said ground plane (4) and said conductive element (1), said resonator (100) being able to transmit a circularly polarized radiofrequency signal when the resonator is supplied by a first transmission line (14a) connected to said conductive element (1) by means of a first connection point (5) and able to receive alternatively a radiofrequency signal circularly polarized in the opposite direction when the resonator is connected to a second transmission line (14b) via a second connection point (6), said resonator comprising on each transmission line (14a, 14b) a switching means (13) mounted in parallel at a distance from the ground plane (4) corresponding to $(2n + 1)\lambda/4$ with $n$ a natural integer, and $\lambda$ the wavelength of the guided wave in the transmission line (14a, 14b) at the operating frequency of the resonator, said switching means (13) making it possible to electrically connect/disconnect said transmission lines (14a, 14b) from said conductive element (1).

2. Patch resonator (100) for nuclear magnetic resonance device according to the preceding claim wherein said switching means is a PIN diode having an off state and an on state, said PIN diode associated with the first transmission line (14a) being off during transmission and on during reception, said PIN diode associated with the second reception transmission line (14b) being on during transmission and off during reception.

3. Patch resonator (100) for nuclear magnetic resonance device according to one of the previous claims wherein said resonator has a shielding (31, 12).

4. Patch resonator (100) for nuclear magnetic resonance device according to claim 1 or 2, wherein said resonator has a first upper shielding (31) and a second lateral shielding (12) at the level of the wafer of said resonator (100).

5. Patch resonator (100) for nuclear magnetic resonance device according to claim 1 or 2, wherein said ground plane (4) covers the lower face of the first dielectric element (3); said resonator comprising:

   - a second dielectric element (10) located above the first dielectric element (3) and the conductive element (1);
   - a first upper shielding (31) positioned on the upper face of the said second dielectric element (10);
   - a second lateral shielding (12) at the edge of said resonator (100).

6. Patch resonator (100) for nuclear magnetic resonance device according to one of the previous claims wherein said resonator comprises four variable capacitors (8) making it possible to adjust the operating frequency of the resonator (100) and/or to adjust the impedance at the level of the first connection point (5) and of the second connection point (6) at the operating frequency of the resonator (100), and/or to adjust the efficiency of the circular polarizations.

7. Patch resonator (100) for nuclear magnetic resonance device according to one of the previous claims, wherein said conductive element (1) has the shape of a disc and has a plurality of radial slits (2), each of the radial slits (2) extending from the edge of the conductive disc (1) up to a given distance from the centre of the conductive disc (1).

8. Patch resonator (100) for nuclear magnetic resonance device according to the preceding claim wherein the resonator comprises eight slits (2).

9. Patch resonator (100) for nuclear magnetic resonance device according to one of claims 7 to 8 wherein the two connection points (5) and (6) are positioned at the surface of the conductive disc (1) on two orthogonal straight lines (AP1, AP2), referred to as main axes, intersecting at the centre of the conductive disc, the two points (5) and (6) being at an identical distance from the centre of the conductive disc (1).

10. Patch resonator (100) for nuclear magnetic resonance device according to one of the previous claims wherein said resonator comprises four appendages (7) arranged around the conductive element (1) and electrically connected to said conductive element (1) forming a triplate line impedance transformer.

11. Patch resonator (100) for nuclear magnetic resonance device according to claim 9 wherein said resonator comprises four variable capacitors (8), said variable capacitors (8) being positioned along two orthogonal straight lines (AS1, AS2), referred to as secondary axes, the secondary axes (AS1, AS2) having an angular offset of 45° with respect to the main axes (AP1, AP2).

12. Patch resonator (100) for nuclear magnetic resonance device according to claims 10 and 11 wherein said variable capacitors (8) are positioned at the intersections of the external edges of the appendages (7) and the two secondary axes (AS1, AS2).

13. High frequency antenna for nuclear magnetic resonance device wherein it comprises a patch resonator (100) according to one of the preceding claims.

14. High frequency antenna for nuclear magnetic resonance device according to the preceding claim wherein the antenna is a multi-channel antenna comprising a plurality of linear resonators having a rectilinear radiating element and/or a plurality of loop resonators comprising a radiating element forming a loop, said radiating elements being used to transmit an excitation radiofrequency signal and/or to receive a relaxation radiofrequency signal.

**Fig. 1**

**Fig. 2**

**Fig. 3**

**Fig. 4**

**Fig. 5**

**Fig. 6**

**Fig. 7a**          **Fig. 7b**          **Fig. 7c**

EP 2 921 873 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- WO 200714105 A

- WO 2007141505 A

### Littérature non-brevet citée dans la description

- **HOFFMANN, J. et al.** Human Brain Imaging at 9.4 T Using a Tunable Patch Antenna for Transmission. *Magnetic Resonance in Medicine,* 2013, vol. 69, 1494-1500
- **B. ZHANG et al.** *Design of a Patch Antenna for Creatinq Traveling Waves at 7 Tesla,* 04 Avril 2009, vol. 17, 4746
- **G. SHAIAN et al.** *Rat brain MRI at 16,4T usinq a capacitively tunable patch antenna in combination with a receive array,* 17 Février 2012, vol. 25 (10
- **Y. PANG et al.** *MR experiment validation of parallel traveling-wave quadrature patch antenna transceiver array,* 23 Avril 2011, vol. 19, 1904

- **Y. PANG et al.** *Parallel Traveling-wave MRI : Antenna Arrav Approach to Traveling-wave MRI for Parallel Transmission and Acquisition,* 17 Avril 2010, vol. 18, 3794
- **X. ZHANG et al.** *Single-feed quadrature coils as transceiver array elements for improved SNR and transmit efficiency,* 04 Avril 2009, vol. 17, 3014
- **WONG, K.-L. ; LIN, Y.-F.** Circularly polarised microstrip antenna with a tuning stub. *Electronic Letters,* 1998, vol. 34 (9), 831-832
- **WONG KIN-LU et al.** *Small slot-coupled circularly-polarised microstrip antenna with modified cross-slot and bent tuning-stub,* 1998, vol. 34 (16